Europäisches Patentamt

European Patent Office

Office européen des brevets

(11) Publication number: **0 275 020**
**A2**

# EUROPEAN PATENT APPLICATION

(21) Application number: **88100053.3**

(51) Int. Cl.⁴: **H01L 29/76**

(22) Date of filing: **05.01.88**

(30) Priority: **12.01.87 US 2084**

(43) Date of publication of application:
**20.07.88 Bulletin 88/29**

(84) Designated Contracting States:
**AT BE CH DE ES FR GB IT LI LU NL SE**

(71) Applicant: **International Standard Electric
Corporation**
**320 Park Avenue**
**New York New York 10022(US)**

(72) Inventor: **Geissberger, Arthur Eugene**
**3332-K Circle Brook Drive**
**Roanoke Virginia 24014(US)**
Inventor: **Sadler, Robert Allen**
**204 Denise Circle**
**Roanoke Virginia 24012(US)**
Inventor: **Luper, Paulette**
**435 W. Burwell Street**
**Salem Virginia 24153(US)**
Inventor: **Balzan, Matthew Lee**
**5439 Lakeland Drive**
**Roanoke Virginia 24018(US)**

(74) Representative: **Morstadt, Volker, Dipl.-Ing.**
**c/o Deutsche ITT Industries GmbH**
**Patent/Lizenzabteilung Postfach 840**
**Hans-Bunte-Strasse 19**
**D-7800 Freiburg/Brsg.(DE)**

(54) **A method of making self-aligned field effect transistors.**

(57) A method of providing a self-aligned gate (SAG) transistor or FET is disclosed. The method maintains the large alignment tolerances inherent in the SAG FET. A reduction in gate resistance is accomplished by including a second gate metallization, which is highly conductive, after the n+ implant and activation anneal. This precludes unavoidable degradation of the conductivity of the second gate metal by interdiffusion with the first (refractory) gate metal. The large tolerance for misalignment of the gate mask level is maintained by a planarization of the anneal cap, into which windows are etched to the first gate metallization. The remaining adjacent encapsulant then acts as an insulator over the FET channel region and allows for gross misalignment of the second gate metallization without FET performance degradation. Using this technique, substantially increased performance can be obtained from a self-aligned FET while maintaining the basic simplicity of the RG process.

FIG. 6C

# A METHOD OF MAKING SELF-ALIGNED FIELD-EFFECT TRANSISTORS

## BACKGROUND

This invention relates to field-effect transistors (FETs) and to methods of making such transistors. More particularly, this invention is concerned with a method for making self-aligned gate (SAG) transistors for use in both analog and digital circuits.

The processes currently being used fall into two categories: (1) Thermally-Stable Refractory Gate (RG), and (2) Substitutional Gate (SG). From a processing standpoint, the RG process is simpler and easier to manufacture than the SG process, but it places stringent requirements on the thermal stability of Schottky gate metallization. The SG approach places no unusual thermal stability requirements on the gate metal but does require the difficult formation of a tri-layer gate substitution mask with a carefully controlled T-shaped profile.

While the RG approach may be superior overall to the SG approach, previous embodiments of the RG approach have suffered from the need to compromise some aspects of the process due to inadequate technology. A major problem in the past has been the high resistivity of the refractory metal, relative to gold used in the SG process, required to achieve the necessary thermal stability of the gate Schottky contact. The high resistivity of the refractory gate metallization complicates the RG approach in that the first-level interconnect metal, which must have lower resistivity than possible with a refractory metal, is defined by an additional mask level rather than the gate mask level as in the SG process. Also the high gate resistance degrades the performance of RG processed FET's, which precludes using this highly manufacturable process to fabricate analog circuits.

## BRIEF SUMMARY OF THE INVENTION

The self-aligned gate (SAG) transistor described herein overcomes the disadvantage of the high gate resistance noted above for the Thermally-Stable Refractory Gate SAG FET. In addition, it maintains the large alignment tolerances inherent in the SAG FET. The reduction in gate resistance is accomplished by including a second gate metallization, which is a higher conductivity and is formed after the n+ implant and activation anneal. This precludes unavoidable degradation of the conductivity of the second gate metal by interdiffusion with the first (refractory) gate metal. The large tolerance for misalignment of the gate mask level is maintained by a planarization of the anneal cap, into which windows are etched to the first gate metallization. The remaining adjacent encapsulant then acts as an insulator over the FET channel region and allows for gross misalignment of the second gate metallization without FET performance degradation. Using this technique, substantially increased performance can be obtained from a self-aligned FET while maintaining the basic simplicity of the RG process.

## OBJECTS OF THE INVENTION

It is an object of the present invention to provide a self-aligned gate type field-effect transistor which overcomes the disadvantages of the prior art.

A further object is to provide a SAG FET gate metallization which has very low gate resistance.

Still a further object is to fabricate SAG analog and digital FETs on the same integrated circuits.

Another object is to planarize and etch windows in a dielectric anneal encapsulant for a second level of gate metallization.

## BRIEF DESCRIPTIONS OF FIGURES

FIG. 1 is a schematic cross-sectional view of a first processing operation according to this invention.

FIGS. 2-6 are cross-sectional views depicting additional steps necessary to provide a field-effect device according to the methods of this invention. FIG. 6 consists of FIG. 6A, 6B and 6C.

## DETAILED DESCRIPTION OF INVENTION

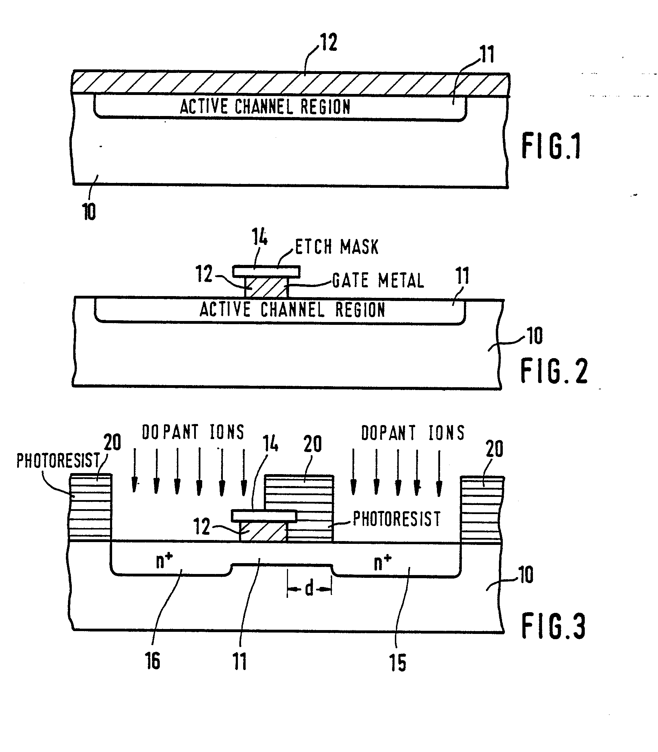

Referring to Fig. 1, there is shown a first step in the process of fabricating a self-aligned field-effect transistor according to this invention. Essentially, a substrate 10 is employed. The substrate 10 may typically be gallium arsenide (GaAs) which is initially cleaned in suitable solvents and then etched to remove a portion of the substrate which may have been damaged by the use of a mechanical slurry polishing process. Techniques for preparing substrates are well known. Many examples of the techniques are described in the above-noted copending applications. These applications fully describe the technique of preparing substrate surfaces for subsequent processing. As indicated, the substrate 10 may be gallium arsenide but any suitable semiconductor material may also be employed. After preparation of the substrate 10, one forms an active channel area 11 for the FET device which channel is fabricated according to conventional techniques. The formation of the active channel area 11 may ·be accomplished by epitaxial layer growth on the substrate which is then followed by electrical isolation of the intended device areas.

Alternatively, one can employ selective ion implantation by utilizing suitable dopants in desired regions of the semiconductor. The entire surface is then coated with a thin layer of suitable metallization 12 having sufficient thermal stability to withstand annealing at high temperatures in the range of 750° to 950°C without degradation of its Schottky barrier properties.

As seen from FIG. 1, the metallization layer 12 is the first level gate metal. Examples of Schottky gate metallizations as 12 which are suitable for this purpose are titanium-tungsten nitride, tungsten nitride and tungsten silicide. It is understood, however, that any metallization which will survive the annealing step to be described may be used. Essentially, FIG. 1 then depicts a cross-sectional view of the device after the completion of the above-noted steps. It is also indicated that the above-noted steps are well-known and, for example, can be implemented by many techniques. Again, it is indicated that by referring to the above-noted copending applications, one can ascertain greater details in the formation of the active channel region 11, as well as the first level gate metal layer 12.

Referring to FIG. 2, there is shown the second step in the process whereby like reference numerals depict corresponding parts. In the FIG. 2, the first level gate metallization layer 12 is patterned into a gate electrode structure for the device. The preferred technique is to define a metal etch mask by the method of evaporation and lift off. The metal etch mask that is designated generally by numeral 14, can consist of nickel, although aluminum is also suitable for this purpose. In any event, after the etch mask has been formed, excess gate metal is then removed by plasma or reactive-ion etching thus leaving the gate metal only on the etch mask 14 as clearly shown in FIG. 2. Again, the formation of etch masks are also provided by well-known processes which are described in greater detail in the above-noted copending applications.

Referring to FIG. 3, a further step in the process is depicted. After selectively etching the gate metal and removing the excess metal by the plasma or reactive-ion etching, the wafer is then coated with a photoresist layer 20 and patterned according to conventional techniques to form openings on both halves of the device as shown in FIG. 3. Suitable dopant ions are then implanted into the semiconductor in the region of the openings thus forming an asymmetrical device structure with the gate adjacent to the n+ region on its source side, but separated from it some distance D on the drain side. The preferred distance for this separation is about 1 um but it could be as little as 0.5 um and as much as the gate to drain electrode distance. Essentially, the preferred dopant ion is silicon, although any N-type dopant ion may be used. As one can see from FIG. 3, the areas 15 and 16 which respectively constitute the drain and source electrodes of the FET device are heavily doped by means of the dopant ions and are n+ regions, indicating high conductivity.

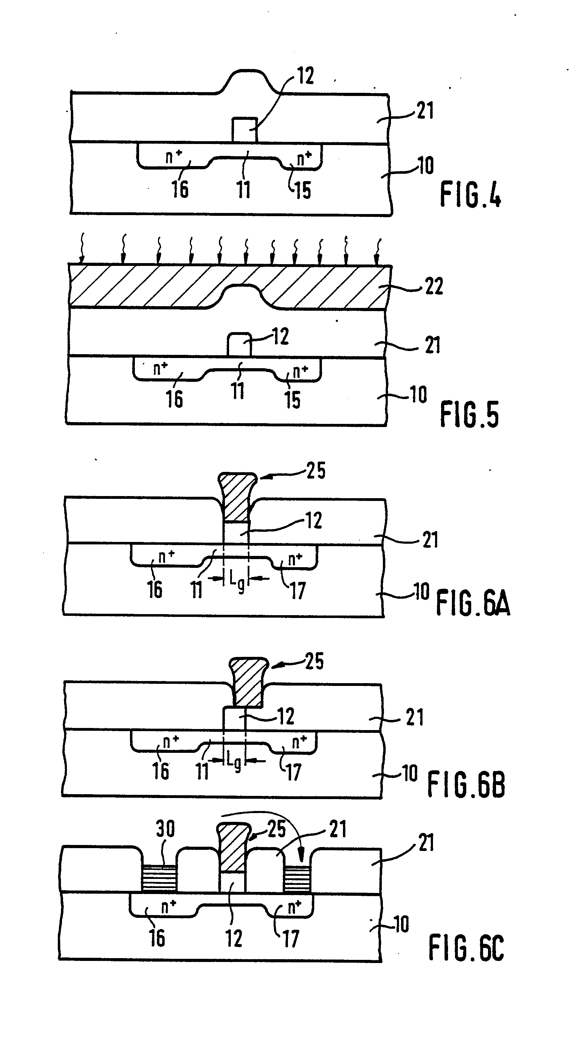

FIG. 4 depicts the next step in the process. In FIG. 4. the etch mask material 14 has been removed and the first level gate metal area as 12 is retained. Again corresponding numerals depict the like parts. After removing the first level gate metal etch mask 14, the wafer 10 is encapsulated with a suitable dielectric material 21 in such a way as to cover the gate electrode structure. A preferred encapsulant is silicon oxy-nitride (SINO), although silicon dioxide and silicon nitride are also suitable for this purpose. The encapsulation technique is also a well-known technique and the encapsulated wafer is then annealed at a temperature and time sufficient to remove ion implant damage from the semiconductor and to activate the implanted dopant ions. Preferred annealing temperatures are in the range of 750° to 900°C if done in a conventional furnace system and in the range of 800° to 1000°C if done in an infrared lamp system by rapid thermal annealing. In any event, both processes are well-known.

Referring to FIG. 5, there is shown the next step in the process. After annealing, the annealed cap is planarized in preparation for gate window etching. This is accomplished by first spinning 5000 angstroms of photoresist onto the encapsulated wafer thus forming the layer 22. The coated wafer is then plasma etched in an admixture of $CF_4$ and $O_2$ in which the ratio of the two gases is adjusted so that the dielectric encapsulant 21 and the photoresist layer 22 have equal etch rates. The wafer is etched until all of the photoresist has been removed in addition to the bulges in the encapsulant caused by the first level gate metal. The exact ratio of the $CF_4/O_2$ mix is determined by the refractive index of the encapsulant.

Referring to FIG. 6A there is shown the next step in the process. Windows are then patterned in the encapsulant 21 over the refractory gate metal area 12 by realigning the gate mask and patterning photoresist material thereupon. Then the unit is chemically etched by chemically etching the encapsulant. Gold 25 is subsequently evaporated and lifted off to produce a second level gate metal area 25 which is firmly bonded to the first level gate area 12. The technique allows the gross misalignment between the first and second gate metallizations without increasing the FET gate lengths designated by $L_g$. This essentially is depicted in FIG. 6B. Hence, as one can see, the metallization area 25 can be substantially misaligned with respect to the first metallization layer 12 and still produce a viable operating device. This is a critical aspect of the above-described process since increasing $L_g$ severely degrades FET performance.

Referring to FIG. 6C, additional windows are then patterned in the encapsulant 21 on either side of the gate electrode and ohmic metallization as 30 is deposited in the openings by evaporation and lift off. The preferred material for these ohmic contacts is a mixture of gold, germanium and nickel. After patterning, the wafer is heated to a temperature between 350° to 500°C to alloy the ohmic contacts resulting in the finished self-aligned gate FET exclusive of external connections to other circuit elements. This is shown in FIG. 6C which essentially depicts a completed device. In any event, it is noted that the two level metallization, which is layer 12 and 25 which forms the gate of the FET device, has a very low sheet resistance which is typically 0.06ohms/sq. and would also be used as the first level interconnect metal if the FET is incorporated in an integrated circuit. Hence, as one can see from FIG. 6C, one has access to the source and drain electrodes of the device via the ohmic contacts 30 and access to the gate electrodes via the second metallization layer 25.

## Claims

1. In a method of fabricating a self-aligned field-effect transistor of the type employing a semiconductor substrate having located on a surface thereof, an active channel region with a first doped area indicative of a source electrode separated from a second doped area indicative of a drain electrode with said source and drain electrodes communicating via said channel region with a gate electrode having a first level gate metallization layer formed on said substrate and positioned on a surface underlying said channel and between said source and drain electrodes the improvement therewith comprising the step of:

forming a second gate metallization layer overlaying at least a portion of said first gate metallization layer to provide a low sheet resistance to said gate electrode due to said first and second layers.

2. The method according to Claim 1, wherein said first level gate metallization is a metal layer capable of withstanding annealing at temperatures in the range of 750°-950°C.

3. The method according to Claim 1, wherein said first level gate metallization is selected from titanium-tungsten nitride, tungsten nitride or tungsten silicide.

4. The method according to Claim 1, wherein said second gate metallization layer is formed from gold.

5. The method according to Claim 1, wherein the step of forming said second metallization layer includes the step of encapsulating said first level gate metallization layer with a dielectric material, annealing said encapsulated substrate at a given temperature, applying a layer of photoresist over said encapsulated layer after annealing, removing said photoresist and forming a window in said encapsulated layer overlaying said first metallization layer, and evaporating said second metallization layer via said window.

6. The method according to Claim 5, wherein the step of encapsulating includes encapsulating said layer with a dielectric selected from silicon oxy-nitride, silicon dioxide or silicon nitride.

7. The method according to Claim 5, wherein said step of annealing is accomplished in a furnace at a temperature in the range of 750°-900°C.

8. The method according to Claim 5, wherein said step of annealing is accommodated in an infrared lamp system at a temperature range between 800° to 1000°C.

9. The method according to Claim 5, wherein the step of applying said photoresist is accomplished by spinning about 5000 Angstroms of photoresist onto said encapsulated layer.

10. The method according to Claim 5, further including the step of plasma etching the coated surface containing the encapsulant and photoresist in an admixture of $CF_4$ and $O_2$ to give equal etch rates to said encapsulant and photoresist.

11. A method of producing a self-aligned field-effect transistor on a semiconductor substrate or wafer comprising the steps of:

forming an active channel region on a surface of said substrate,

coating said surface with a thin layer of a first metal of a given conductivity patterning said metal layer with a metal etch mask to form a gate electrode structure,

etching away selective portions of said mask to form a gate electrode area,

coating said etched wafer with a patterned photoresist to form openings on either side of said gate electrode area indicative of source and drain areas,

doping said areas to provide high conductivity regions,

encapsulating said wafer and gate metal area with a dielectric,

annealing said encapsulated wafer at a given temperature,

applying a photoresist layer over said encapsulated layer and then etching away said photoresist layer leaving said encapsulated layer,

forming a window in said encapsulated layer over said gate area, and

evaporating a second higher conductivity metal layer via said window onto said first metal layer to form a gate electrode of first and second metals.

12. The process according to Claim 11, further including the step of forming additional windows in said encapsulant at said source and drain areas, and evaporating ohmic contacts at said source and drain areas.

13. The process according to Claim 11, wherein the step of forming said active channel region includes selective ion implantation on said wafer surface.

14. The process according to Claim 11, wherein said step of coating said surface includes coating said surface with a thin metal layer selected from titanium-tungsten nitride, tungsten nitride or tungsten silicide.

15. The process according to Claim 11, wherein the step of encapsulating includes encapsulating a dielectric selected from silicon oxynitride, silicon dioxide or silicon nitride.

16. The process according to Claim 11, wherein the step of etching away said photoresist layer includes plasma etching in an admixture of $CF_4$ and oxygen in a ratio to to impart the same etching rate to said encapsulant and photoresist layers.

17. The process according to Claim 11, wherein the step of annealing is at a temperature range between 750°-1000°C.

18. The process according to Claim 11, wherein said second evaporated layer is gold, with said first layer being nickel.

19. The process according to Claim 12, wherein said ohmic contacts are evaporated by using a metal selected from a mixture of gold, germanium and nickel.

20. The process according to Claim 12, further including the step of heating said wafer after evaporation of said ohmic contacts at a temperature between 350° to 500°C to alloy said contacts.

FIG.1

FIG.2

FIG.3

FIG.4

FIG.5

FIG.6A

FIG.6B

FIG.6C